# FASCICULE DE BREVET EUROPEEN

(11) **EP 2 179 236 B1**
(45) Date de publication et mention de la délivrance du brevet: **10.08.2016**
(21) Numéro de dépôt: 08787122.4
(22) Date de dépôt: 11.08.2008
(51) Int. Cl.: F26B 5/04, F26B 25/22, H01L 21/67, H01L 21/673, H01L 21/677

(54) **PROCÉDÉ DE TRAITEMENT D'UN SUPPORT DE TRANSPORT POUR LE CONVOYAGE ET LE STOCKAGE ATMOSPHÉRIQUE DE SUBSTRATS SEMI-CONDUCTEURS**
VERFAHREN ZUR BEHANDLUNG EINES TRANSPORTTRÄGERS FÜR DIE ATMOSPHÄRISCHE LAGERUNG UND BEFÖRDERUNG VON HALBLEITERSUBSTRATEN
METHOD OF TREATING A TRANSPORT SUPPORT FOR THE ATMOSPHERIC STORAGE AND CONVEYANCE OF SEMICONDUCTOR SUBSTRATES

(30) Priorité: 13.08.2007 FR 0757049
(43) Date de publication de la demande: 28.04.2010
(73) Titulaire: Pfeiffer Vacuum, 74000 Annecy (FR)
(72) Inventeur: GODOT, Erwan, F-74000 Annecy (FR); THOLLOT, Rémi, F-42320 Saint Christo en Jarez (FR); FAVRE, Arnaud, F-74000 Annecy (FR)
(74) Mandataire: Croonenbroek, Thomas Jakob
(86) Numéro de dépôt international: PCT/EP2008/060548
(87) Numéro de publication internationale: WO 2009/021941

(56) Documents cités:
- EP-A- 1 574 265
- EP-A- 1 630 858
- DE-A1- 4 230 899
- DE-A1-102005 004 912
- FR-A- 2 626 366
- JP-A- 59 161 826
- US-A- 3 006 077
- US-A- 4 977 688
- US-A- 5 263 264
- US-A- 5 273 589
- US-A- 5 830 279
- US-A- 5 896 674
- US-A1- 2005 081 890
- US-B1- 6 202 318

## Description

### DOMAINE TECHNIQUE DE L'INVENTION

La présente invention se rapporte à un procédé de traitement des supports de transport pour le convoyage et le stockage atmosphérique de substrats, tels que les enceintes de transport de plaquettes de semi-conducteurs ou de photomasques, les supports de transport pouvant avoir subi au préalable un nettoyage par un liquide, tel qu'un lavage à l'eau pure.

Les enceintes de transport et de stockage déterminent un espace confiné sous pression atmosphérique, séparé de l'environnement d'utilisation et de transport du substrat, pour le transport et le stockage d'un ou de plusieurs substrats.

Dans l'industrie de fabrication de semi-conducteurs, ces enceintes permettent de transporter les substrats, tels que des plaquettes semi-conductrices ou des photomasques, d'un équipement à l'autre ou de stocker les substrats entre deux étapes de fabrication.

On distingue notamment les enceintes standardisées de transport et de stockage de plaquettes à ouverture latérale de type FOUP (« Front Opening Unified Pod » en anglais) ou à ouverture par le fond de type SMIF Pod (« Standard Mechanical Interface Pod » en anglais), les enceintes dites « open cassette » en anglais, les enceintes standardisées de transport et de stockage de photomasques de type RSP (« Reticle SMIF Pod » en anglais), les enceintes de transport de substrats pour l'industrie du solaire.

Ces enceintes de transport sont formées de matériaux tels que le polycarbonate, qui peuvent dans certains cas concentrer les contaminants et en particulier des contaminants organiques, basiques, aminés, acides et dopants (AMC), pouvant résulter de la fabrication des enceintes de transport et/ou de leur utilisation.

En outre, au cours de la fabrication des semi-conducteurs, les enceintes de transport sont manipulées, ce qui conduit à la formation de particules polluantes qui se logent dans les parois des enceintes de transport et qui les contaminent. Les particules collées sur les parois des enceintes de transport peuvent ensuite se décoller, retomber sur les substrats stockés dans ces enceintes et les détériorer.

On prévoit donc le nettoyage régulier de ces enceintes par leur lavage avec un liquide tel que de l'eau déionisée. Cette étape de lavage, qui dure de 5 à 7 minutes, est suivie d'une étape de séchage beaucoup plus longue (entre 5 heures et 8 heures) comportant par exemple une phase dans laquelle les enceintes de transport sont chauffées par convexion d'air chaud chauffé par infrarouges, et centrifugées, suivie d'une phase dans laquelle les enceintes de transport sont mises en attente à l'air libre.

En effet, les résidus de fluide nettoyant et plus particulièrement de vapeur d'eau sont des contaminants importants qu'il est nécessaire de supprimer.

L'inconvénient de l'étape de séchage est qu'elle n'est pas suffisamment efficace.

En effet, la température de l'air de chauffage par convexion est limitée à 50°C car il est nécessaire de ne pas endommager le matériau constitutif de l'enceinte de transport et de ne pas entraîner sa déformation la rendant inapte à une utilisation robotisée. Une telle température est alors trop basse pour éliminer tout le liquide résiduel.

De même, la vitesse de rotation des enceintes de transport centrifugées est limitée pour ne pas créer de nouvelles particules contaminantes.

Des résidus d'eau restent alors accrochés dans les parois des enceintes.

On constate d'autre part que le séchage est inhomogène.

En effet, les enceintes de transport possèdent une géométrie complexe, comportant de nombreuses zones mortes difficiles d'accès et qui constituent des zones de piégeage de l'humidité et des autres corps étrangers.

Par ailleurs, les enceintes de transport ne proviennent pas toutes du même processus de fabrication, et il peut arriver que certaines enceintes nécessitent des durées de séchage à l'air libre plus longues que d'autres. Par ailleurs certaines parois d'enceintes sont comme neuves, tandis que d'autres ont déjà été beaucoup manipulées et présentent un état de surface avec plus de porosité.

Même après une longue période d'attente à l'air libre, certaines enceintes de transport restent encore humides.

En outre, le séchage à l'air libre nécessite l'immobilisation des enceintes de transport pendant plusieurs heures. En moyenne, cinq à huit heures sont nécessaires pour que le flux de désorption des parois des enceintes ait atteint un niveau suffisamment bas et acceptable.

Les industriels prévoient donc la mise en place de grandes salles de séchage dans lesquelles les enceintes de transport sont stockées en attendant d'être totalement séchées.

De même, d'importants parcs d'enceintes de transport doivent être prévus.

La mise en place et la gestion de la logistique de ces salles blanches dont l'atmosphère doit parfois être régulée en propreté, température, humidité et pression, constituent un investissement lourd et coûteux.

Par ailleurs, les critères de contamination de plus en plus exigeants contraignent les industriels à augmenter la fréquence de nettoyage des enceintes de transport et donc, à agrandir encore l'espace nécessaire pour leur stockage en attendant la fin de l'étape de séchage.

Il y a donc un besoin d'assurer un nettoyage plus efficace et plus rapide des supports de transport tels que les enceintes de transport.

Une difficulté est que le matériau constituant l'essentiel d'un support de transport est généralement poreux, apte à contenir des corps étrangers qu'il faut éliminer ou bloquer.

Une autre difficulté est qu'un support de transport ne supporterait pas un nettoyage par contact, qui risquerait de générer des particules polluantes.

On a pu envisager de recourir à un rayonnement par micro-ondes pour chauffer l'humidité résiduelle et favoriser son élimination. Toutefois, ce procédé ne peut pas être employé avec les nouvelles générations de supports de transports qui comprennent des éléments métalliques et des dispositifs d'identification par ondes RF, qui ne peuvent pas être reliés à la masse.

Une contrainte supplémentaire est que la contamination surfacique du support de transport doit être minime : généralement la surface intérieure du support de transport doit être dépourvue de particules de taille supérieure à 65 nm, elle doit être dépourvue d'humidité, et elle doit être dépourvue de charges électriques perturbantes.

Le document US5,273,589 divulgue un autre exemple de procédé de traitement.

### EXPOSE DE L'INVENTION

Le but de la présente invention est ainsi de proposer un procédé de traitement de supports de transport, qui améliore et accélère de façon significative l'élimination des corps étrangers, notamment les composés de contamination moléculaire (AMC, VOC) et/ou l'humidité après une étape de lavage, permettant de réduire leur temps d'immobilisation, d'assurer la propreté satisfaisante des parois de supports de transport.

En pratique, l'invention vise à assurer le traitement en moins de 10 minutes, sans dégrader ni déformer le support de transport, et sans créer des charges électrostatiques perturbantes.

A cet effet, l'invention propose un procédé de traitement d'un support de transport pour le convoyage et le stockage de substrats, comprenant les caractéristiques de la revendication 1.

Grâce à l'action combinée de la pression gazeuse subatmosphérique et du rayonnement infrarouge agissant sur la surface à traiter, l'élimination des corps étrangers est particulièrement rapide et complète, permettant d'obtenir de façon inattendue un support de transport propre dans le temps désiré, c'est-à-dire en moins de 10 minutes, sans dégrader ni déformer le support de transport.

Pour atteindre un temps de traitement le plus court possible, inférieur à 10 minutes environ, on cherche à descendre le plus bas possible la pression gazeuse à laquelle est soumise la surface à traiter. Mais, une pression trop basse accélère l'évaporation et abaisse simultanément la température des liquides, et il est essentiel d'éviter la solidification des corps étrangers liquides à éliminer, car une telle solidification allonge très sensiblement le temps d'élimination de ces corps étrangers, et rend quasiment impossible la détection de fin du traitement, de sorte que la qualité de nettoyage obtenue n'est pas satisfaisante.

Pour éviter une telle solidification intempestive, au cours du procédé de l'invention, on fait en sorte que la pression subatmosphérique reste supérieure à la pression du point triple du diagramme des phases des corps étrangers liquides à éliminer.

Simultanément il y a intérêt à augmenter l'efficacité du rayonnement infrarouge afin de placer les corps étrangers à éliminer à une température assez haute pour éviter leur solidification, tout en maintenant cette température en dessous d'une limite de température admissible au-delà de laquelle le support de transport peut être dégradé, par exemple par une déformation le rendant impropre à une utilisation robotisée, ou par exemple par une modification structurelle du matériau le rendant poreux et sensible à la pollution.

Pour cela, le rayonnement infrarouge présente de préférence un spectre d'émission ayant des intensités maximales au voisinage de la ou des longueurs d'onde d'absorption du ou des corps étrangers à éliminer.

Selon l'invention, le rayonnement infrarouge est un rayonnement intermittent, comprenant une étape initiale continue de mise à température appropriée de la surface à traiter. Le rayonnement agit ainsi de façon préférentielle sur les corps étrangers à éliminer à base d'eau, et l'étape initiale permet d'accélérer la mise à température appropriée, réduisant ainsi sensiblement le temps de traitement. En outre, cela permet de contrôler séparément le spectre d'émission d'infrarouges et la température de la surface à traiter.

En pratique, pour réaliser le rayonnement intermittent, on peut avantageusement mesurer une température de test représentative de la température de la surface à traiter, et on peut piloter le rayonnement infrarouge en fonction de ladite température de test, de façon à maintenir ladite température de surface à traiter au voisinage d'une température de consigne en dessous d'un seuil de température maximale admissible. De la sorte, on peut se placer au plus près de la température maximale admissible, et réduire ainsi le temps de traitement.

Egalement dans le souci de réduire le temps de traitement, en se plaçant à la pression la plus basse possible, on peut avantageusement mesurer la pression gazeuse subatmosphérique et la comparer à une pression de consigne pour piloter, en fonction de la comparaison, des moyens de réglage de pression tels qu'une vitesse de pompage, une conductance de pompage, une conductance d'injection de flux gazeux, pour amener et maintenir la pression gazeuse subatmosphérique au voisinage de la pression de consigne.

Comme indiqué, précédemment, l'une des difficultés pour éliminer les corps étrangers, réside dans la forme complexe des supports de transport. Cette forme complexe comporte des zones de piégeage ou renfoncements dans lesquels les corps étrangers peuvent s'accumuler et devenir ainsi très difficile à éliminer.

On peut réduire encore le temps d'élimination des corps étrangers dans ces zones en renfoncement en prévoyant une étape au cours de laquelle on injecte un flux gazeux localisé proche d'au moins une zone de piégeage de corps étrangers sur la surface à traiter. Le flux gazeux localisé participe à l'élimination des éléments polluants de la zone de piégeage, réduisant sensiblement le temps de traitement. Le gaz utilisé peut être par exemple l'azote ou l'hélium, ce dernier étant plus efficace et permettant de réduire encore le temps de traitement.

En fin de traitement, on prévoit une étape de conditionnement au cours de laquelle on soumet la surface à traiter à une descente progressive de température jusqu'au voisinage de la température ambiante et à une remontée progressive simultanée de pression gazeuse jusqu'au voisinage de la pression atmosphérique avec injection d'un flux de gaz propre, dépourvu des corps étrangers à éliminer.

Le flux de gaz propre permet, lors de cette étape, de saturer la zone de surface à traiter en molécules de gaz propre, ce qui évite ensuite à la surface traitée d'être à nouveau polluée par l'atmosphère ambiante par un effet d'éponge lors de la remontée en pression et du refroidissement.

Le flux de gaz propre doit avantageusement être choisi à vitesse suffisamment faible, par exemple inférieure à 0,4 m/s au voisinage de la pression atmosphérique, mais largement réparti pour permettre un débit important, en évitant ainsi la création de charges électrostatiques perturbantes et l'entraînement de particules polluantes.

Avec un tel flux gazeux important mais à vitesse faible, on évacue la phase vapeur proche des résidus liquides, et on déplace ainsi l'équilibre liquide-vapeur, ce qui accélère le traitement.

Pour des raisons économiques et de sécurité, à la fin du procédé subatmosphérique, on utilise de préférence l'azote ou l'air.

Selon un mode de réalisation avantageux, on peut mesurer un paramètre représentatif de l'élimination des corps étrangers de la surface à traiter, et on interrompt le traitement lorsque le paramètre représentatif atteint une valeur de référence.

De la sorte, on peut assurer un traitement efficace en adaptant le traitement aux conditions réelles que présente le support de transport avant le traitement.

Par exemple, le paramètre représentatif peut être le poids du support de transport, ou la quantité d'humidité ou d'AMC en sortie de la pompe à vide, ou la pression gazeuse dans la chambre étanche.

### DESCRIPTION SOMMAIRE DES DESSINS

D'autres avantages et caractéristiques apparaîtront à la lecture de la description de l'invention, faite en relation avec les dessins annexés sur lesquels :
- la figure 1 est un organigramme montrant les différentes étapes d'un procédé selon un mode de réalisation de l'invention,
- la figure 2 est une vue en perspective de côté d'une station de traitement en position ouverte, selon un mode de réalisation de l'invention,
- la figure 3 représente un schéma synoptique de la station de traitement de la figure 2,
- la figure 4 représente un graphique de l'évolution du poids mesuré d'un support de transport en fonction du temps lors d'une mise sous vide,
- la figure 5 illustre le diagramme de phase de l'eau,
- la figure 6 illustre la courbe d'absorption des rayonnements infrarouges par l'eau ;
- les figures 7, 8 et 9 illustrent, respectivement en vue de face, en vue d'arrière et en vue de côté en coupe, un capteur de température selon un mode de réalisation de l'invention,
- la figure 10 illustre schématiquement le fonctionnement du capteur de température des figures 7 à 9, et
- la figure 11 est un diagramme temporel illustrant les variations de rayonnement infrarouge, de température et de pression au cours du procédé.

### DESCRIPTION DES MODES DE REALISATION PREFERES

Sur ces figures jointes, les éléments identiques portent les mêmes numéros de référence.

Par souci de clarté, les étapes du procédé sont numérotées à partir de 100, et les éléments de la station sont numérotés de 1 à 60.

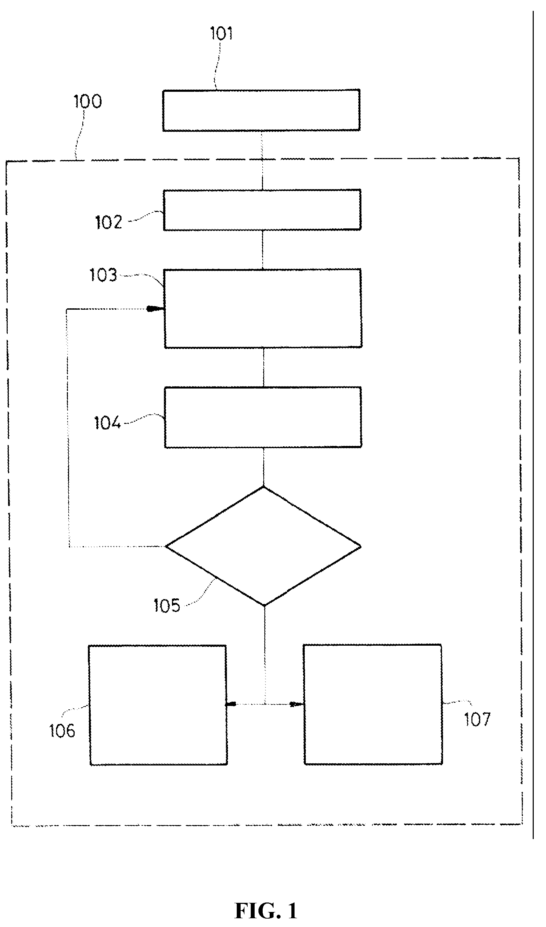

La figure 1 illustre un organigramme d'un procédé de traitement (à l'intérieur du rectangle 100 en pointillé) d'un support de transport pour le convoyage et le stockage de substrats.

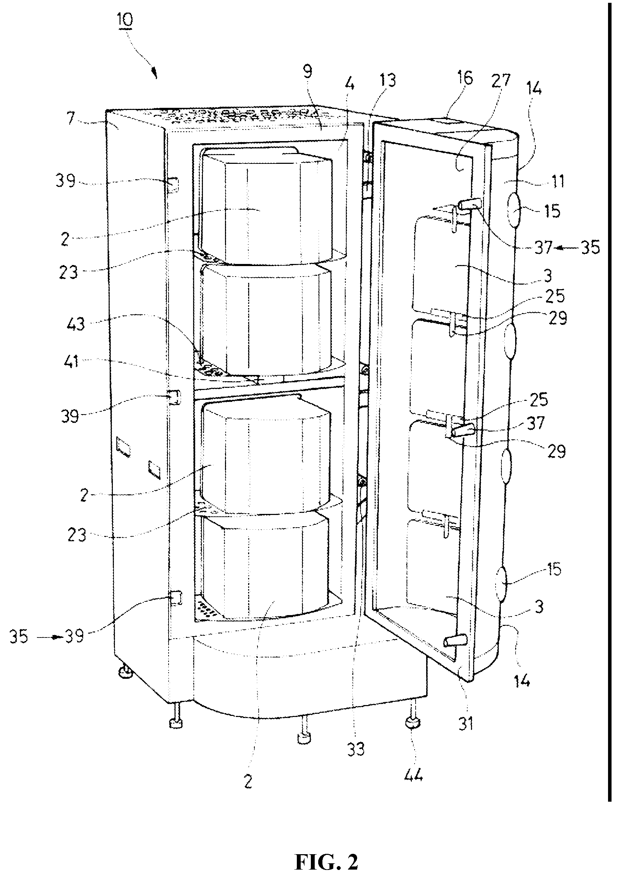

Ce procédé s'applique à un support de transport 1, tel que représenté sur la figure 2, pouvant par exemple avoir subi au préalable un nettoyage par un liquide, tel qu'un lavage à l'eau déionisée selon l'étape 101 représentée en figure 1.

Le support de transport 1 est un moyen de convoyage et de stockage atmosphérique de substrats tels que des plaquettes de semi-conducteurs, des photomasques, des films minces pour l'industrie du solaire.

Par exemple, le support de transport 1 est une enveloppe périphérique 2 d'enceinte de transport, une porte d'enceinte 3 et/ou l'enceinte de transport elle-même. L'enceinte de transport peut notamment être une enceinte de transport standardisée de type FOUP, SMIF Pod, RSP ou « Open Cassette », ou une enceinte de transport de substrats pour capteurs solaires.

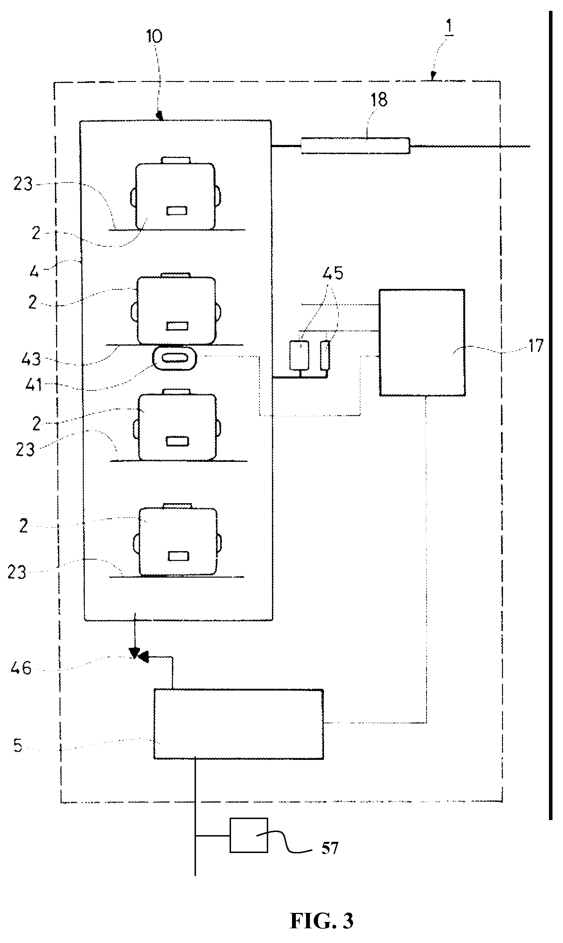

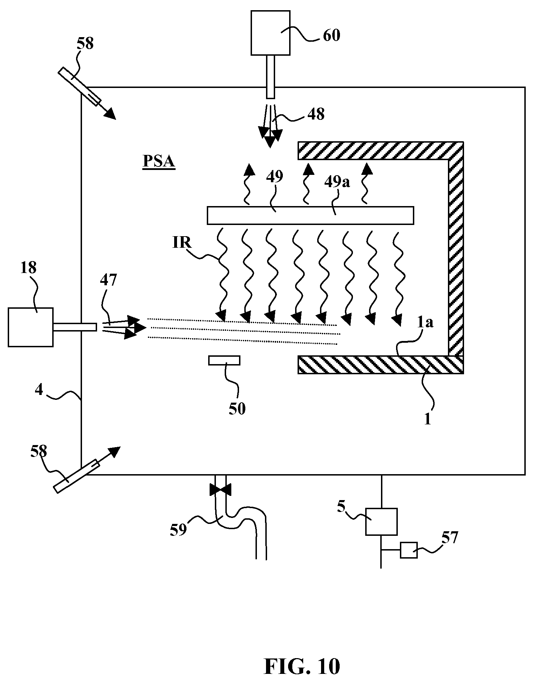

Le procédé selon l'invention se caractérise en ce qu'il comporte une étape de traitement, illustrée sur les figures 3 et 10, au cours de laquelle on place le support de transport 1 dans une chambre étanche 4 raccordée à une pompe à vide 5 (étape 102) et on soumet une surface à traiter 1a du support de transport 1 à l'action combinée d'une pression gazeuse subatmosphérique PSA par l'intermédiaire de la pompe à vide 5 (étape 103) et d'un rayonnement infrarouge IR.

Le traitement des parois permet à la fois d'obtenir un séchage de niveau satisfaisant après une dizaine de minutes seulement, et d'optimiser le dégazage des parois.

Ce traitement du support de transport 1 vise à éliminer, par séchage et désorption, les résidus liquides et sous forme de vapeur, et parfois même certains résidus solides, notamment des agents nettoyants tels que l'eau.

Par ailleurs, on observe que le procédé permet d'obtenir des supports de transport dont le niveau de flux désorbé, et donc de séchage, est complètement reproductible d'un support à l'autre, à la différence des procédés de l'art antérieur.

En effet, dans les procédés de séchage de l'art antérieur, d'une part des résidus de vapeur d'eau pouvaient rester logés dans des zones mortes des supports de transport 1, et d'autre part le niveau de dégazage dépendait de l'historique des supports de transport.

La reproductibilité du procédé permet donc de s'assurer qu'après un même procédé de traitement faisant suite à un nettoyage liquide, les supports de transport 1 ont le même niveau de propreté.

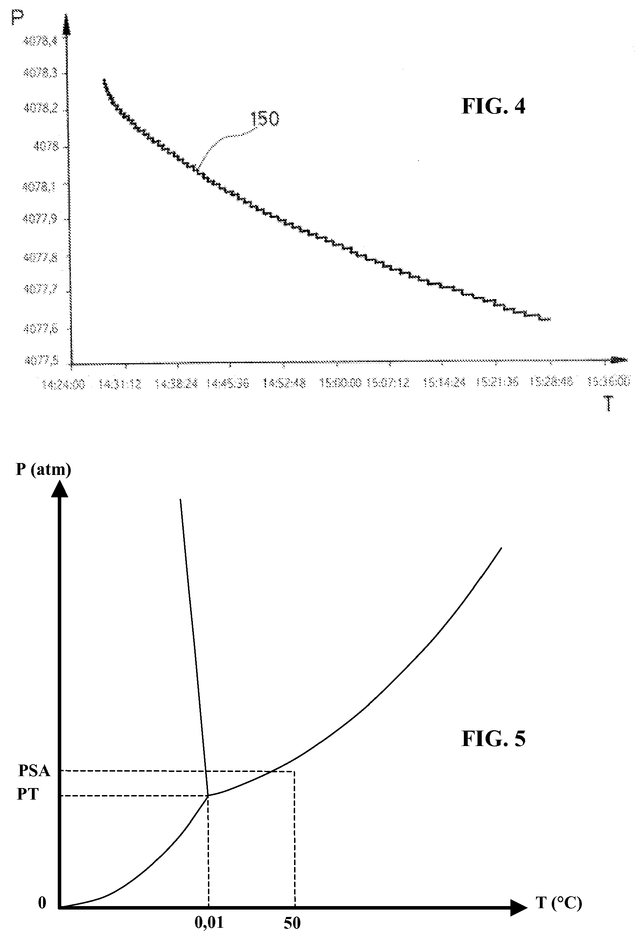

On soumet par exemple le support de transport 1 à un vide primaire pour lequel la pression subatmosphérique PSA est inférieure à 1000 mbar, et de préférence de l'ordre de 100 mbar ou de l'ordre de 10 mbar, étant observé que la pression subatmosphérique PSA reste supérieure à la pression PT du point triple du diagramme des phases des corps étrangers à éliminer. Par exemple, dans le cas de l'eau comme corps étranger à éliminer, la pression PT du point triple est de 6 mbar (voir figure 5).

Pour évacuer à un niveau encore inférieur le flux de dégazage des parois des supports de transport 1, après évacuation des corps étrangers liquides tels que l'eau sur la surface à traiter 1a, on soumet le support de transport 1 à un vide secondaire pour lequel la pression subatmosphérique est inférieure à 0.1 mbar, et de préférence de l'ordre de 0.001 mbar.

On peut ainsi prévoir par exemple, de commencer à soumettre le support de transport 1 à un pompage primaire, puis, alors que le niveau souhaité de séchage est obtenu, de basculer en pompage secondaire.

Selon le procédé, on chauffe par rayonnement infrarouge IR le support de transport 1 pendant que l'on soumet le support de transport 1 à une pression subatmosphérique PSA.

Le support de transport 1 est chauffé à une température prédéfinie par le rayonnement infrarouge IR.

La puissance émise du rayonnement IR est contrôlée en mesurant la température TM du matériau du support de transport 1, pour éviter de dépasser la température maximale admissible TA du matériau du support de transport 1.

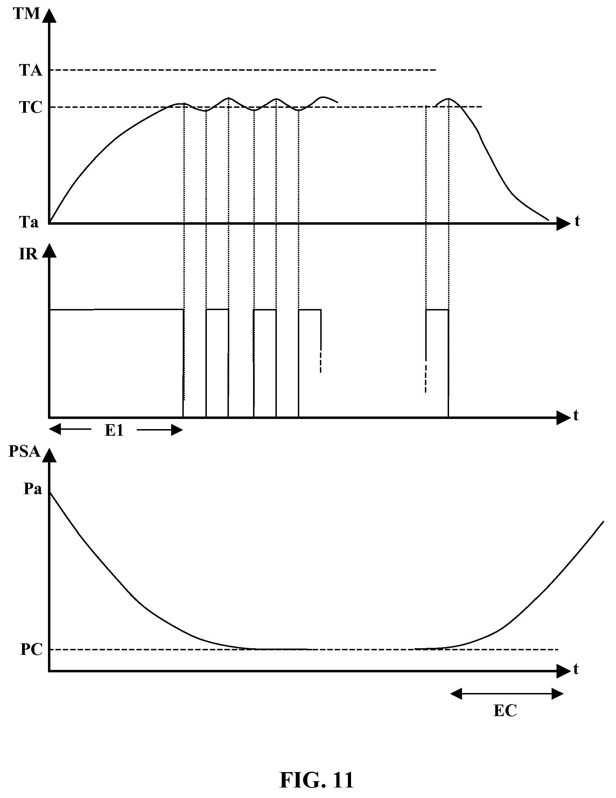

La figure 11 illustre un mode de réalisation préféré du processus de chauffage par infrarouge. Dans ce cas, le rayonnement infrarouge IR est intermittent. Il comprend avantageusement une étape initiale E1 continue de mise à température appropriée de la surface à traiter 1a. Ensuite, le rayonnement infrarouge IR est alternativement interrompu et établi pendant des durées satisfaisantes pour maintenir la température du matériau TM au voisinage d'une température de consigne TC. Simultanément, le fait de prévoir un rayonnement infrarouge intermittent permet de contrôler la température de la surface à traiter 1a tout en contrôlant le spectre de longueur d'onde des moyens de génération de rayonnement infrarouge.

Pendant l'étape initiale E1 dans laquelle l'émission d'infrarouges est continue, la température TM du matériau s'élève rapidement jusqu'à la température de consigne TC. Ensuite, on maintient la température TM au voisinage de la température de consigne TC, qui elle-même est inférieure à un seuil de température maximale admissible TA.

En pratique, on mesure une température de test représentative de la température TM de la surface à traiter 1a et on pilote le rayonnement infrarouge IR en fonction de ladite température de test : lorsque la température TM dépasse la température de consigne TC d'un écart prédéterminé, par exemple un degré, on interrompt le rayonnement infrarouge IR. Ensuite, lorsque la température TM devient inférieure à la température de consigne TC selon un écart prédéterminé, par exemple un degré, on rétablit le rayonnement infrarouge. Il en résulte une courbe de température TM telle qu'illustrée sur le diagramme temporel de la figure 11.

Par ailleurs, on peut choisir le spectre d'émission de longueur d'onde du rayonnement infrarouge IR de manière que le chauffage s'effectue en surface et dans les premières couches à l'intérieur du matériau du support de transport 1, et qu'il s'effectue préférentiellement sur les corps étrangers liquides à éliminer. Une longueur d'onde voisine de 3 µm est pour cela avantageuse pour éliminer l'eau.

On peut aussi choisir de faire agir des rayonnements infrarouges à deux ou plusieurs longueurs d'onde différentes propres à être absorbées sélectivement par deux ou plusieurs types d'éléments à éliminer.

En pratique le rayonnement infrarouge IR peut avantageusement présenter un spectre d'émission ayant des intensités maximales au voisinage de la ou des longueurs d'onde d'absorption du ou des corps étrangers à éliminer.

La température de consigne TC est avantageusement supérieure à la température ambiante, et de préférence de l'ordre de 50°C.

Il est essentiel que la pression subatmosphérique PSA soit la plus basse possible, mais reste en permanence supérieure à la pression PT du point triple des corps à éliminer, à défaut de quoi les corps liquides à éliminer peuvent se solidifier et leur élimination devient très lente. Pour cela, on peut avantageusement mesurer la pression gazeuse PSA à l'intérieur de la chambre étanche 4 et on la compare à une pression de consigne PC pour piloter, en fonction de la comparaison, des moyens de réglage de pression, tels qu'une vitesse de pompage, une conductance de pompage 46, une conductance d'injection de flux gazeux 18, pour amener et maintenir la pression gazeuse subatmosphérique PSA au voisinage de la pression de consigne PC.

On a pu constater qu'une accélération sensible du traitement peut être obtenue en prévoyant d'injecter un flux gazeux 47 localisé proche des zones de piégeage des corps étrangers sur la surface à traiter 1a du support de transport 1. Un tel flux gazeux localisé 47 (figure 10) favorise l'entraînement des molécules et particules au voisinage de la surface à traiter 1a.

De préférence le retour au voisinage de la température ambiante et de la pression atmosphérique s'effectue en maintenant le support de transport 1 à l'intérieur de la chambre étanche 4, car le refroidissement favorise l'adsorption d'un gaz propre que l'on peut utiliser pour remettre la chambre étanche 4 à pression atmosphérique, et qui passive la surface à traiter 1a.

En pratique, on prévoit une étape de conditionnement EC (figure 11), au cours de laquelle on soumet la surface à traiter 1a à une remontée progressive de pression gazeuse PSA jusqu'au voisinage de la pression atmosphérique Pa, et à une descente de température TM jusqu'au voisinage de la température ambiante Ta avec injection d'un flux de gaz propre 48 dépourvu des corps étrangers à éliminer. Le flux de gaz propre 48 (figure 10) n'est pas localisé, c'est-à-dire qu'il doit être diffus dans la chambre étanche 4. Le flux de gaz propre 48 est choisi à vitesse suffisamment faible et largement réparti pour permettre un débit important et éviter la création de charges électrostatiques perturbantes et l'entraînement de particules polluantes sur la surface à traiter 1 a.

On peut supposer que le temps nécessaire au traitement sera sensiblement équivalent pour des enceintes de même type ayant subi de préférence la même étape préalable de lavage. Dans ce cas, on peut interrompre le traitement à l'issue d'une durée prédéfinie caractéristique du type du support de transport 1, depuis laquelle on soumet le support de transport 1 à une pression subatmosphérique.

Selon une variante avantageuse représentée sur l'organigramme de la figure 1, on mesure un paramètre caractéristique de l'élimination des corps étrangers de la surface à traiter 1a du support de transport 1 (étape 104), et on compare l'évolution de ce paramètre avec une référence (étape 105), c'est à dire une valeur de référence ou une courbe de référence, qui tient compte du type de support de transport 1.

La référence est caractéristique d'un niveau satisfaisant de désorption du support de transport 1, et donc du séchage, et on peut interrompre le traitement lorsque le paramètre représentatif atteint la référence.

Chaque type de support de transport 1 peut être caractérisé par un ensemble de paramètres physiques tels que la taille, le matériau, la structure, la géométrie. On cite en particulier des types d'enceintes standardisées, telles qu'une enceinte de type FOUP, une enceinte de type SMIF Pod, une enceinte de type RSP ou de type "open Cassette", ou les enceintes de transport de substrats pour capteurs solaires.

On peut alors prévoir de remonter la pression dans la chambre étanche 4 à la pression atmosphérique au plus tôt lorsque le paramètre mesuré est égal ou inférieur à la référence.

La pression atmosphérique Pa est la pression qu'ont les supports de transport 1 dans leur environnement d'utilisation, telle que la pression atmosphérique de la salle blanche.

Lorsque le paramètre mesuré est égal ou inférieur à la référence, alors le niveau de flux de désorption a atteint un niveau suffisamment faible.

Dans ce cas, on peut choisir soit de remonter la pression dans la chambre étanche 4 et d'extraire le support de transport 1 (étape 106), soit de stocker le support de transport 1 sous vide pour qu'il continue à désorber ses parois en attendant soit d'être réutilisé, soit de libérer la place dans la chambre étanche 4 (étape 107).

Selon une possibilité, le paramètre caractéristique est la pression totale ou partielle du gaz dans la chambre étanche 4.

En effet, la mesure de la pression totale en régime de vide limite du pompage est un indicateur du flux désorbé dans la chambre étanche 4, provenant en majorité du dégazage du support de transport 1 à traiter.

Cette méthode de mesure est très efficace pour de forts flux de gaz (de l'ordre de quelque sccm). Toutefois, lorsque les flux de désorption sont relativement faibles (inférieurs à quelques sccm), il peut arriver que cette technique de mesure manque de précision.

Par ailleurs lorsqu'un flux gazeux 47 est injecté dans la chambre étanche 4, le signal du flux de désorption peut se retrouver noyé avec celui du flux injecté.

On peut aussi prévoir que le procédé comporte une étape supplémentaire de purge comprenant une opération de remplissage en gaz de purge durant laquelle on introduit un gaz de purge dans la chambre étanche 4, et une opération de pompage du gaz de purge durant laquelle on extrait le mélange du gaz de purge et du gaz initial de la chambre étanche 4 par pompage.

Selon une autre possibilité, le paramètre caractéristique est le poids mesuré du support de transport 1.

En effet, la valeur du poids varie avec l'élimination des corps étrangers et avec le flux dégazé des parois du support de transport 1.

De préférence, on peut commencer la mesure à partir du régime permanent de la pompe à vide 5 pour éviter les perturbations de la mesure dues par exemple à la poussée d'Archimède subie par le support de transport 1 et aux mouvements de flux dans la chambre étanche 4.

La figure 4 est un graphique dans lequel le poids P en grammes est donné en ordonnée, et en abscisse le temps T en heures, minutes et secondes. La courbe 150 représente le poids mesuré du support de transport 1 en fonction du temps lors d'une mise sous vide de la chambre étanche 4.

On constate que le poids du support 1 diminue avec l'augmentation du temps. En effet les parois du support de transport 1 dégazent sous vide. La mesure du poids est donc un bon indicateur du niveau de traitement du support de transport 1.

Selon une autre possibilité, la référence peut être la quantité d'humidité ou d'AMC en sortie de la pompe à vide 5.

Avantageusement, la référence peut être une variation temporelle prédéfinie du paramètre caractéristique.

Ainsi, lorsque la variation temporelle de la pression ou du poids mesuré devient trop faible, le flux désorbé en fonction du temps peut ne plus être suffisamment important pour justifier le maintien sous vide du support de transport 1.

Alternativement, la référence peut être une valeur seuil prédéfinie.

Pour illustrer l'efficacité du procédé de traitement selon l'invention, on a procédé à des tests sur des éprouvettes placées dans une chambre étanche 4 et soumises aux différents moyens d'action du procédé.

Dans tous les cas, on a fait agir le rayonnement infrarouge IR sur l'éprouvette.

On a comparé la rapidité du traitement entre un premier cas à pression atmosphérique et un second cas à pression proche du point triple de l'eau (10 mbar) : le gain en rapidité a été de 67 % dans le cas d'une pression proche du point triple.

On a testé l'importance du maintien correct de la pression, par comparaison entre une pression trop basse (6 mbar) conduisant à la formation de glace, et une pression correcte (6.7 mbar) assurant l'absence de formation de glace pendant toute la durée du séchage. Le gain de rapidité a été de 57 %. On a recherché ensuite l'effet de l'insertion d'un flux gazeux pour assurer le maintien de la pression, pour une même pression de 50 mbar. L'insertion d'un flux gazeux a permis un gain de 13 % de rapidité, par rapport à un traitement sans flux gazeux.

On a ensuite recherché l'effet du positionnement de la surface à traiter 1a par rapport au flux gazeux inséré. On a ainsi trouvé qu'en positionnant la surface à traiter 1a sur le parcours du flux gazeux injecté, on peut obtenir un gain de rapidité de 19 %.

On a aussi recherché l'effet de la nature du gaz injecté. En utilisant l'hélium, on a obtenu un gain de rapidité de 22 % par rapport à une injection d'azote, dans les mêmes conditions.

Par ailleurs, on a effectué des tests sur des supports de transport de type FOUP, en mesurant le dégazage résiduel du support de transport à l'issue d'un traitement :
a) après un chauffage par infrarouges (50°C) à pression atmosphérique Pa pendant 1 heure, le dégazage résiduel était 2,5 sccm,
b) après une mise sous vide sans chauffage additionnel pendant 1 heure, le dégazage résiduel était 0,77 sccm,
c) après une mise sous vide avec chauffage additionnel par infrarouges (50°C) pendant 1 heure, le dégazage résiduel était 0,6 sccm.

Cela montre la synergie d'une combinaison du vide et du rayonnement infrarouge.

Selon l'invention, et comme illustré par la figure 2, on prévoit également une station de traitement 10 d'un support de transport 1 pour le convoyage et le stockage atmosphérique de substrats, pour la mise en oeuvre d'un procédé de traitement tel que précédemment décrit.

La station 10 comprend au moins une chambre 4 étanche, de préférence montée sur un châssis 7.

La chambre étanche 4 de la station de traitement 10 est destinée à être raccordée à des moyens de pompage à pompe à vide 5 (voir figure 3), et est conformée pour recevoir au moins un support de transport 1, tel qu'une enceinte de transport de substrats, ayant une surface à traiter.

La station de traitement 10 comprend au moins une source de rayonnement infrarouge 49, conformée pour soumettre la surface à traiter 1a du support de transport 1 à un rayonnement infrarouge IR.

Sur la figure 2, on a représenté une station de traitement 10 recevant quatre enceintes de transport de type FOUP.

Selon une première variante, la pompe à vide 5 est une pompe à vide primaire.

Alternativement, la pompe à vide 5 peut comporter une canalisation destinée à être reliée à une pompe à vide primaire et une dérivation de la canalisation en amont de la pompe à vide primaire, destinée à être reliée à une pompe secondaire, de manière à pouvoir basculer d'un pompage primaire en un pompage secondaire lors de la mise en oeuvre du procédé de traitement.

La chambre étanche 4 est de préférence de forme cylindrique et en inox pour résister à une mise sous vide. Elle comporte en outre une ouverture 9 pouvant être obturée par un capot de fermeture 11 avantageusement monté sur une charnière 13 (figure 2).

Le capot de fermeture 11 comporte avantageusement en face avant 14 au moins un hublot 15, en verre par exemple, permettant à un opérateur de vérifier la présence ou non d'un support de transport 1 à l'intérieur.

On prévoit avantageusement un hublot 15 à hauteur de chaque support de transport 1.

En outre, la face avant 14 du capot de fermeture 11 comporte avantageusement une tourelle de signalisation 16 de l'état de fonctionnement de la station de traitement 10, et un écran d'affichage (non visible) relié à une unité centrale 17 (figure 3) de la station de traitement 10.

Comme visible sur le schéma des figures 3 et 10, la chambre étanche 4 comporte des moyens d'introduction de gaz propre 60, tels que des moyens d'introduction d'azote sec, pour remettre la chambre étanche 4 à pression atmosphérique après traitement du support de transport 1.

Lorsque le support de transport 1 est une enceinte de transport, on peut prévoir avantageusement de la placer ouverte dans la chambre étanche 4, de manière à ne pas déformer la paroi de l'enceinte lors de sa mise sous vide.

Pour cela, la station de traitement 10 comporte par exemple des étagères 23, 25 destinées à soutenir chaque support de transport 1.

Comme visible sur la figure 2, la station de traitement 10 comporte de préférence une première série d'étagères 23 sur lesquelles sont posées les enveloppes périphériques 2 d'enceintes ainsi qu'une deuxième série d'étagères 25 sur lesquelles sont posées les portes 3 correspondantes.

Avantageusement, la deuxième série d'étagères 25 soutient les portes 3 en position verticale dans un renforcement interne 27 du capot de fermeture 11.

Les étagères de la deuxième série d'étagères 25 comportent en outre une languette de verrouillage 29 pour retenir la porte 3 de l'enceinte placée en dessous d'elle.

Pour limiter l'encombrement et pour simplifier l'accès aux supports de transport 1, on prévoit que la station de traitement 10 soit apte à recevoir la partie des supports 1 la plus encombrante dans la partie fixe de la chambre étanche 4, et la seconde partie dans le renforcement 27 du capot de fermeture 11.

La chambre étanche 4 comporte en outre un joint de porte 31 disposé sur la périphérie de l'ouverture 9, de manière à étanchéifier la chambre étanche 4 lorsque le capot de fermeture 11 est en position de fermeture (non représentée).

On prévoit en outre que la station de traitement 10 comporte au moins un vérin 33, de préférence pneumatique, monté sur une articulation de la charnière 13 de la chambre étanche 4, pour pouvoir comprimer le joint de porte 31 dans la position fermée de la chambre étanche 4.

Pour améliorer encore le guidage du capot de fermeture 11 sur l'ouverture 9, on prévoit plusieurs vérins 33 régulièrement répartis sur la longueur de la charnière 13 de la station de traitement 10.

On prévoit de préférence trois vérins 33 situés aux trois articulations de la charnière 13, comme représenté sur la figure 2.

Pour assurer la compression homogène du joint de porte 31, on prévoit en outre au moins un guide 35, formé d'une part par une goupille 37, de préférence solidaire du capot 11, et formé d'autre part par un trou 39 correspondant, ménagé dans la périphérie de l'ouverture 9 de la chambre étanche 4, à l'extérieur du joint de porte 31.

On dispose de préférence autant de guides 35 que d'articulations charnière, régulièrement répartis sur le côté de l'ouverture 9 de la chambre étanche 4 opposé à celui comportant la charnière 13, et sensiblement à même hauteur que les vérins 33.

Ainsi, lors de la fermeture de la chambre étanche 4, le capot de fermeture 11 est dans un premier temps guidé et centré par les goupilles 37 sur l'ouverture 9 de la chambre étanche 4.

Une fois mis en place, l'actionnement du vérin 33 permet dans un deuxième temps, de plaquer le capot de fermeture 11 contre l'ouverture 9 et ainsi de comprimer le joint de porte 31, rendant la chambre étanche 4.

Cet agencement permet de limiter les contraintes en cisaillement sur le joint de porte 31 à l'endroit de la charnière 13.

Alternativement, on prévoit d'une part, au moins deux guides 35 du capot de fermeture 11, disposés de façon sensiblement symétrique sur le pourtour de l'ouverture 9 de la chambre étanche 4 pour centrer le capot de fermeture 11 sur l'ouverture 9 de la chambre étanche 4.

Dans ce mode de réalisation alternatif, on prévoit d'autre part, une pompe 5 dimensionnée pour pouvoir comprimer le joint de porte 31 par la seule mise sous vide de la chambre étanche 4.

Sur les figures 3 et 10, la station de traitement 10 comporte en outre des moyens de commande ayant une unité centrale 17, pour d'une part la gestion de mise à la pression subatmosphérique (PSA) de la chambre étanche 4 par l'intermédiaire de moyens de pompage, et pour d'autre part le pilotage de la source de rayonnement infrarouge 49. De la sorte, la station de traitement 10 est apte à soumettre la surface à traiter 1a à l'action combinée d'une pression gazeuse subatmosphérique et d'un rayonnement infrarouge IR.

Pour le pilotage de la source de rayonnement infrarouge 49, comme illustré sur la figure 10, on prévoit avantageusement au moins un capteur de température 50, disposé dans la chambre étanche 4, et apte à mesurer une température de test représentative de la température TM de la surface à traiter 1a. Le capteur de température 50 est solidaire de la chambre étanche 4, et placé dans une zone qui reçoit le rayonnement infrarouge IR de manière similaire à la surface à traiter 1a, en provenance de la source de rayonnement 49. On fait en sorte que l'action du rayonnement infrarouge IR génère, sur le capteur de température 50, des élévations de température similaires de celles subies par la surface à traiter 1 a.

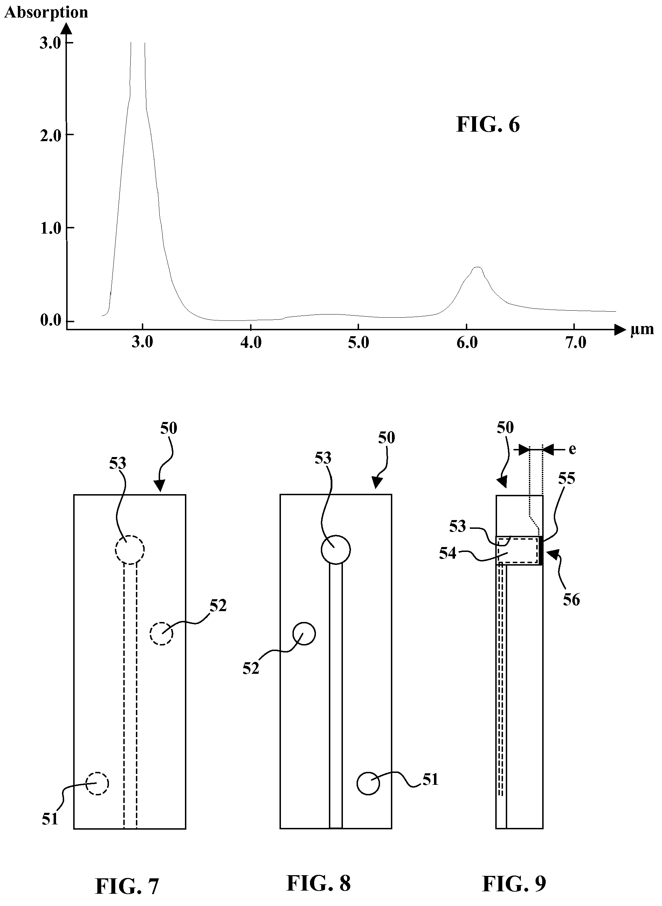

En pratique, le capteur de température 50 peut être réalisé comme illustré sur les figures 7 à 9 : le capteur de température peut être une plaque généralement parallélépipédique en un matériau similaire de celui constituant les supports de transport 1 à traiter, par exemple en PEEK chargé de carbone, de longueur 60 mm environ, de largeur 20 mm environ, d'épaisseur 8 mm environ, avec des trous de positionnement 51 et 52 pour sa fixation à la paroi de l'enceinte étanche 4, et avec un trou borgne 53 pour l'engagement d'une sonde de température 54.

Le trou borgne 53 est obturé par une couche de test 55, de faible épaisseur e (1 ou 2 dixièmes de millimètres environ), dont une face 56 est soumise au rayonnement infrarouge IR, et dont la face opposée est au contact de la sonde de température 54. La faible épaisseur e de la couche de test 55 permet de garantir une faible inertie thermique et une bonne réactivité du capteur de température 50.

En pratique, les moyens de commande à unité centrale 17 comprennent un programme de pilotage d'infrarouges qui scrute les données de température produites par le capteur de température 50, qui provoque l'alimentation de la source de rayonnement infrarouge 49 lorsque la température mesurée par le capteur de température 50 est inférieure de plus d'un écart prédéterminé à une température de consigne TC elle-même inférieure à un seuil de température admissible TA et qui interrompt l'alimentation de la source de rayonnement infrarouge 49 lorsque la température mesurée par le capteur de température 50 dépasse ladite température de consigne TC de plus d'un écart prédéterminé.

Dans le mode de réalisation illustré sur la figure 10, le support de transport 1 est un élément creux de type boîte de transport. Dans ce cas, la source de rayonnement infrarouge 49 comprend avantageusement au moins une partie de source 49a apte à s'engager dans l'intérieur du support de transport 1 en forme de boîte. La source de rayonnement infrarouge 49 est ainsi au plus près des zones concaves de boîte susceptibles de piéger les corps étrangers à éliminer, et on réduit les éventuelles zones d'ombre.

Toujours dans le mode de réalisation illustré sur la figure 10, la station de traitement comprend en outre des premiers moyens d'injection de gaz 18 pour générer un premier flux gazeux 47 localisé au voisinage de la surface à traiter 1a. Ce premier flux gazeux 47 localisé peut être utilisé comme moyen pour maintenir la pression gazeuse PSA dans la chambre étanche 4 pendant le traitement. Dans ce cas, l'unité centrale peut gérer le débit gazeux assuré par les premiers moyens d'injection de gaz 18.

Toutefois, pour l'étape de conditionnement EC, on prévoit des seconds moyens d'injection de gaz 60 pour injecter un flux de gaz propre 48 dans la chambre étanche 4 à l'écart de la surface à traiter 1a.

Par ailleurs, l'unité centrale 17 peut être reliée à des capteurs permettant le contrôle d'un paramètre caractéristique de l'avancement du traitement. Ces capteurs peuvent être des jauges de pression 45 (figure 3) de la chambre étanche 4, et/ou la balance 41, et/ou un capteur d'humidité et/ou d'AMC 57 (figure 10) en sortie de la pompe à vide 5.

Alternativement ou de façon complémentaire pour la mesure de pression, on peut en outre prévoir d'utiliser un dispositif de contrôle (non représenté) des espèces gazeuses comportant une cellule d'excitation dérivée pouvant être connectée, via une vanne, à une canalisation de la pompe à vide 5 ou directement sur la chambre étanche 4, pour être en communication avec les gaz de la chambre étanche 4.

Le dispositif de contrôle des espèces gazeuses comporte en outre une antenne d'excitation électromagnétique alimentée par un générateur de puissance, disposée autour de la cellule de manière à former un plasma à l'intérieur de celle-ci.

La radiation lumineuse émise par le plasma est ensuite captée et transmise jusqu'à un spectromètre optique. La transmission peut être assurée par une fibre optique, ou par un connecteur adapté. Le spectromètre optique génère des images du spectre optique détecté, et les transmettant par exemple, à l'unité centrale 17.

Avantageusement, et pour permettre à la station 10 de fonctionner de façon complètement automatique, l'unité centrale 17 peut comporter des moyens d'identification du support de transport 1, tels que des lecteurs de codes barres, des lecteurs RFID (transducteur) ou un récepteur.

Selon un autre mode de réalisation particulier ne faisant pas partie de l'invention. la station 10 comporte au moins une balance électronique 41 agencée pour pouvoir mesurer l'évolution du poids mesuré d'au moins un support de transport 1.

En effet, la mesure du poids peut être corrélée avec le flux de dégazage des parois des supports de transport 1 permettant ainsi de déterminer l'évolution du séchage de ceux-ci.

Pour que la mesure soit significative, la précision de la mesure est avantageusement de l'ordre de un centième de gramme pour une pleine échelle de quelques kilogrammes (environ 4 kg pour une enceinte de transport de type FOUP et environ 700 g pour une enceinte de type RSP).

Pour limiter les perturbations dues à l'environnement extérieur, on prévoit aussi que la station de traitement 10 comporte un moyen d'amortissement des vibrations (non représenté), placé entre une face inférieure du châssis 7 de la station et le sol, de préférence sous les pieds 44 de la station 10.

Dans le cas où la station 10 est apte à contenir plusieurs supports de transport 1 et pour limiter les coûts, on détermine l'évolution du séchage des supports de transport 1 par le contrôle d'un seul support de transport 1.

En effet, on peut considérer que l'information issue de la mesure d'un support de transport 1 peut s'appliquer à l'évolution du séchage de tous les supports de transport 1 dans le cas où ceux-ci sont de même type et sont issus d'une même étape précédente de nettoyage.

Ainsi, et tel qu'illustré par la figure 2, la station de traitement 10 comporte par exemple trois étagères ou plateaux fixes 23, destinés à recevoir chacun une enveloppe périphérique 2 de boîte de transport de type FOUP et comporte en outre une balance 41 surmontée d'un plateau mobile 43, apte à mesurer le poids d'une quatrième enveloppe périphérique 2 de boîte de transport de type FOUP.

Avantageusement, la balance 41 comporte un circuit électrique de rétroaction comportant au moins une bobine de compensation placée dans un champ magnétique d'aimants permanents de manière à pouvoir générer une compensation électromagnétique lorsqu'un support de transport 1 applique une force sur la balance 41.

Après lecture du zéro, la force de compensation requise pour l'équilibre de la balance 41 est proportionnelle au poids sur le plateau 43, et l'intensité du courant est ainsi convertie en poids.

Selon une variante de réalisation, la station de traitement 10 est raccordée à un équipement de lavage d'un support de transport (non représenté).

Dans cette variante, on prévoit que la station 10 et/ou l'équipement comporte un moyen de convoyage du support de transport 1 pour le convoyage depuis l'équipement de lavage vers la chambre étanche 4 de la station de traitement 10.

Par exemple, le moyen de convoyage est un robot de préhension du support de transport 1 ou un tapis roulant.

On peut également prévoir une chambre de transfert entre une ou plusieurs stations de traitement 10 et un équipement de lavage (non représentée).

On peut également prévoir un équipement de traitement comportant une pompe à vide 5 et au moins une station de traitement, de préférence apte à recevoir un unique support de transport 1 de type FOUP.

Ainsi, en fonctionnement, la station de traitement 10 est apte à mettre en oeuvre un procédé de traitement faisant suite à une étape de lavage.

On commence par placer le support de transport 1 dans la chambre étanche 4 que l'on ferme à l'aide du capot 11.

Puis, on évacue le gaz contenu dans la chambre étanche 4 par l'intermédiaire de la pompe 5, et on génère un rayonnement infrarouge IR.

L'évacuation du gaz par pompage, et le rayonnement infrarouge IR, peuvent être avantageusement arrêtés selon le résultat de la comparaison de l'évolution du paramètre caractéristique de l'avancement de la déshumidification avec la référence.

Ensuite, on laisse refroidir le support de transport 1 et remonte la pression de la chambre étanche 4 à la pression atmosphérique par l'introduction de gaz propre grâce aux seconds moyens d'introduction de gaz 60, puis on ouvre le capot de fermeture 11 pour sortir le support de transport 1 de la chambre étanche 4.

Selon un autre mode de réalisation, la station de traitement 10 peut comprendre en outre des moyens de lavage 58 tels que des jets fixes ou mobiles, avec des moyens d'écoulement 59, permettant le lavage des supports de transport 1 directement dans la chambre étanche 4 elle-même, avant l'étape de traitement sous vide. On évite ainsi l'utilisation de moyens de manutention, et les risques de recontamination associés. On réduit le temps de traitement global. On favorise en outre l'efficacité du traitement grâce à une décontamination simultanée et à un contrôle des moyens de lavage eux-mêmes. Cela permet aussi une réduction des coûts et un gain de place.

Par le procédé de traitement selon l'invention d'un support de transport, on met le support de transport 1 sous vide et on chauffe sélectivement sa surface à traiter 1a. On favorise ainsi l'évaporation des liquides sur les parois du support de transport 1, et notamment dans les premières couches du matériau du support, et ainsi on accélère le traitement d'élimination des corps étrangers.

## Revendications

1. Procédé de traitement d'un support de transport (1) pour le convoyage et le stockage de substrats, comprenant :
- une étape de traitement au cours de laquelle on soumet une surface à traiter (1a) du support de transport (1) à l'action combinée d'une pression gazeuse subatmosphérique (PSA) et d'un rayonnement infrarouge (IR) pour éliminer les corps étrangers de ladite surface à traiter (1a) et au cours de laquelle, la surface à traiter (1a) est d'abord soumise à un vide primaire pour lequel la pression subatmosphérique (PSA) est supérieure à la pression (PT) du point triple du diagramme des phases des corps étrangers à éliminer,
- une étape de conditionnement (EC) au cours de laquelle on soumet la surface à traiter (1a) à une remontée progressive de pression gazeuse (PSA) jusqu'au voisinage de la pression atmosphérique (Pa), et à une descente de température (TM) jusqu'au voisinage de la température ambiante (Ta) avec injection d'un flux de gaz propre (48), dépourvu des corps étrangers à éliminer, **caractérisé en ce qu'**au cours de l'étape de traitement,
- la surface à traiter (1a) est soumise à un vide secondaire pour lequel la pression subatmosphérique (PSA) est inférieure à 0,1 mbar et
- le rayonnement infrarouge (IR) est intermittent et comprend une étape initiale (E1) continue de mise à température appropriée de la surface à traiter (1a).

2. Procédé selon la revendication précédente, **caractérisé en ce que** le rayonnement infrarouge (IR) présente un spectre d'émission ayant des intensités maximales au voisinage de la ou des longueurs d'onde d'absorption du ou des corps étrangers à éliminer.

3. Procédé selon l'une des revendications précédentes, **caractérisé en ce qu'**on mesure une température de test représentative de la température (TM) de la surface à traiter (1a), et on pilote le rayonnement infrarouge (IR) en fonction de ladite température de test de façon à maintenir ladite température (TM) de surface à traiter au voisinage d'une température de consigne (TC) inférieure à un seuil de température maximale admissible (TA).

4. Procédé selon l'une quelconque des revendications précédentes, **caractérisé en ce qu'**on mesure ladite pression gazeuse subatmosphérique (PSA) et on la compare à une pression de consigne (PC) pour piloter, en fonction de la comparaison, des moyens de réglage de pression tels qu'une vitesse de pompage, une conductance de pompage, une conductance d'injection de flux gazeux, pour amener et maintenir la pression gazeuse subatmosphérique (PSA) au voisinage de la pression de consigne (PC).

5. Procédé selon l'une quelconque des revendications précédentes, **caractérisé en ce qu'**il comprend une étape au cours de laquelle on injecte un flux gazeux localisé (47) proche d'au moins une zone de piégeage de corps étranger sur la surface à traiter (1a).

6. Procédé selon la revendication précédente, **caractérisé en ce que** le flux de gaz propre (48) est choisi à vitesse suffisamment faible mais largement réparti pour permettre un débit important en évitant ainsi la création de charges électrostatiques perturbantes et l'entraînement de particules polluantes.

7. Procédé selon l'une quelconque des revendications précédentes, **caractérisé en ce qu'**on mesure un paramètre (tel que poids du support de transport, quantité d'humidité ou d'AMC en sortie de pompe à vide, pression partielle ou totale dans la chambre étanche) représentatif de l'élimination des corps étrangers de la surface à traiter (1a), et on interrompt le traitement lorsque le paramètre représentatif atteint une référence.

## Patentansprüche

1. Verfahren zum Bearbeiten eines Transportträgers (1) für die Beförderung und die Aufbewahrung von Substraten, das Folgendes umfasst:
- einen Bearbeitungsschritt, in dessen Verlauf eine zu bearbeitende Oberfläche (1a) des Transportträgers (1) der kombinierten Wirkung eines unteratmosphärischen Drucks (PSA) und einer Infrarotstrahlung (IR) unterworfen wird, um Fremdkörper von der zu bearbeitenden Oberfläche (1a) zu entfernen, und in dessen Verlauf die zu bearbeitende Oberfläche (1a) zuerst einem primären Unterdruck unterworfen wird, für den der unteratmosphärische Druck (PSA) größer als der Druck (PT) des Tripelpunkts des Phasendiagramms der zu entfernenden Fremdkörper ist,
- einen Konditionierungsschritt (EC), in dessen Verlauf die zu bearbeitende Oberfläche (1a) einem allmählichen Anstieg des Gasdrucks (PSA) bis in die Umgebung des Atmosphärendrucks (Pa) und einem Temperaturabfall (TM) bis in die Nähe der Umgebungstemperatur (Ta) unter Einleitung eines Stroms eines sauberen Gases (48), das keine zu entfernenden Fremdkörper enthält, unterworfen wird,
**dadurch gekennzeichnet, dass** im Verlauf des Bearbeitungsschrittes
- die zu bearbeitende Oberfläche (1a) einem sekundären Unterdruck unterworfen wird, bei dem der unteratmosphärische Druck (PSA) kleiner als 0,1 mbar ist, und
- die Infrarotstrahlung (IR) intermittierend ist und einen ununterbrochenen anfänglichen Schritt (E1), um die zu bearbeitende Oberfläche (1a) auf eine geeignete Temperatur zu bringen, umfasst.

2. Verfahren nach dem vorhergehenden Anspruch, **dadurch gekennzeichnet, dass** die Infrarotstrahlung (IR) ein Emissionsspektrum aufweist, das in der Nähe der einen oder der mehreren Absorptionswellenlängen der zu entfernenden Fremdkörper maximale Intensitäten hat.

3. Verfahren nach einem der vorhergehenden Ansprüche, **dadurch gekennzeichnet, dass** eine Prüftemperatur, die die Temperatur (TM) der zu bearbeitenden Oberfläche (1a) repräsentiert, gemessen wird und die Infrarotstrahlung (IR) in Abhängigkeit von dieser Prüftemperatur gesteuert wird, derart, dass die Temperatur (TM) der zu bearbeitenden Oberfläche in der Nähe einer Solltemperatur (TC), die kleiner als ein maximal zulässiger Temperaturschwellenwert (TA) ist, gehalten wird.

4. Verfahren nach einem der vorhergehenden Ansprüche, **dadurch gekennzeichnet, dass** der unteratmosphärische Gasdruck (PSA) gemessen wird und mit einem Solldruck (PC) verglichen wird, um als Funktion des Vergleichs Druckregulierungsmittel, etwa eine Pumpgeschwindigkeit, einen Pumpleitwert oder einen Einleitungsleitwert des Gasstroms zu steuern, um den unteratmosphärischen Gasdruck (PSA) in die Nähe des Solldrucks (PC) zu bringen und dort zu halten.

5. Verfahren nach einem der vorhergehenden Ansprüche, **dadurch gekennzeichnet, dass** es einen Schritt umfasst, in dessen Verlauf ein Gasstrom (47) eingeleitet wird, der sich in der Nähe wenigstens einer Fremdkörper-Einfangzone auf der zu bearbeitenden Oberfläche (1a) befindet.

6. Verfahren nach dem vorhergehenden Anspruch, **dadurch gekennzeichnet, dass** der Strom (48) eines sauberen Gases mit einer ausreichend geringen Geschwindigkeit, jedoch breit verteilt, gewählt wird, um einen hohen Durchsatz zu ermöglichen, wodurch die Erzeugung störender elektrostatischer Ladungen und die Mitnahme von Schmutzpartikeln vermieden werden.

7. Verfahren nach einem der vorhergehenden Ansprüche, **dadurch gekennzeichnet, dass** ein Parameter (wie etwa das Gewicht des Transportträgers, die Menge an Feuchtigkeit oder AMC am Ausgang der Unterdruckpumpe, der Partialdruck oder der Gesamtdruck in der dichten Kammer), der die Entfernung von Fremdkörpern von der zu bearbeitenden Oberfläche (1a) repräsentiert, gemessen wird und die Bearbeitung unterbrochen wird, wenn der repräsentative Parameter einen Referenzwert erreicht.

## Claims

1. A method of treating a transport support (1) for the conveyance and storage of substrates, including:
- a treatment stage during which a surface to be treated (1a) on the transport support (1) is subjected to the combined action of a subatmospheric gaseous pressure (PSA) and infrared radiation (IR) to remove foreign bodies from said surface to be treated (1a) and during which the surface to be treated (1a) is first subjected to a primary vacuum for which the subatmospheric pressure (PSA) is greater than the pressure (PT) of the triple point of the phase diagram of the foreign bodies to be removed,
- a conditioning stage (EC) during which the surface to be treated (1a) is subjected to a gradual increase in gaseous pressure (PSA) to around the atmospheric pressure (Pa), and to a temperature decrease (TM) to around the ambient temperature (Ta) with injection of a clean gas flow (48) free from the foreign bodies to be removed,
**characterized in that** during the treatment stage,
- the surface to be treated (1a) is subjected to a secondary vacuum for which the subatmospheric pressure (PSA) is less than 0.1 mbar and
- The infrared radiation (IR) is intermittent and includes a continuous initial stage (E1) of bringing the surface to be treated (1a) to an appropriate temperature.

2. A method according to the preceding claim, wherein the infrared radiation (IR) presents an emission spectrum with maximum intensities of around the absorption wavelength(s) of the foreign body or bodies to be removed.

3. A method according to either of the preceding claims, wherein a test temperature is measured which is representative of the temperature (TM) of the surface to be treated (1a), and the infrared radiation (IR) is controlled in accordance with said test temperature so as to maintain said temperature (TM) of the surface to be treated at around a temperature setting (TC) lower than a maximum allowable temperature threshold (TA).

4. A method according to any one of the preceding claims, wherein said subatmospheric gaseous pressure (PSA) is measured and compared with a pressure setting (PC) to control, depending on the comparison, means of adjusting the pressure such as a pumping speed, a pumping conductance, a gaseous flow injection conductance, to bring the subatmospheric gaseous pressure (PSA) to around the pressure setting (PC) and maintain it at that level.

5. A method according to any one of the preceding claims, wherein it includes a stage during which a localized gaseous flow (47) is injected close to at least one area for trapping a foreign body on the surface to be treated (1a).

6. A method according to the preceding claim, wherein the clean gas flow (48) is chosen at sufficiently low speed but widely distributed to allow a high flow rate, to avoid the creation of interfering electrostatic charges and the entrainment of pollutant particles.

7. A method according to any one of the preceding claims, wherein a parameter (such as the weight of the transport support, amount of moisture or of AMC at the outlet of the vacuum pump, partial or total pressure in the sealed chamber) representative of the removal of the foreign bodies from the surface to be treated (1a) is measured, and the treatment is interrupted when the representative parameter reaches a reference.
